# EUROPÄISCHE PATENTSCHRIFT

(11) **EP 0 424 362 B1**
(45) Veröffentlichungstag und Bekanntmachung des Hinweises auf die Patenterteilung: **14.09.1994**
(21) Anmeldenummer: 91100350.7
(22) Anmeldetag: 03.11.1988
(51) Int. Cl.: C30B 33/00, C30B 29/14

(54) **Verfahren zur Verringerung des Wassergehaltes in piezoelektrischen GaPO4-Kristallelementen und nach dem Verfahren hergestellte Kristallelemente**
Process for lowering the water content of piezoelectric GaPO4 crystal elements and crystals produced thereby
Procédé pour baisser le contenu en eau de cristaux piézo-électriques de GaPO4 et des cristaux ainsi obtenus

(30) Priorität: 11.11.1987 AT 2983/87
(43) Veröffentlichungstag der Anmeldung: 24.04.1991
(62) Teilanmeldung aus: 88890275.6
(73) Patentinhaber: AVL Gesellschaft für Verbrennungskraftmaschinen und Messtechnik mbH.Prof.Dr.Dr.h.c. Hans List, 8020 Graz (AT)
(72) Erfinder: Engel, Günter, Dipl.-Ing., Dr., A-8430 Leitring (AT); Krempl, Peter W., Dr., A-8047 Graz/Ragnitz (AT); List, Helmut, Dipl.-Ing., A-8010 Graz (AT)
(74) Vertreter: Krause, Walter, Dr. Dipl.-Ing.

(56) Entgegenhaltungen:
- EP-A- 0 123 809
- FR-A- 2 524 497
- JOURNAL OF CRYSTAL GROWTH, Band 80, Nr. 1, Januar 1987, Seiten 133-148, Elsevier Science Publishers B.V., Amsterdam, NL; J.C. JUMAS et al.: "Crystalgrowth of berlinite, AIP04: physical characterization and comparison with quartz"
- JOURNAL OF CRYSTAL GROWTH, Band 79, Teil 1, Nr. 1-3, 2. Dezember 1986, Seiten 215-218, Elsevier Science Publishers B.V., Amsterdam, NL; S.I. HIRANO et al.: "Hydrothermal synthesis of gallium orthophosphate crystals"

## Beschreibung

Die Erfindung betrifft ein Verfahren zur Verringerung des Wassergehaltes in piezoelektrischen GaPO₄-Kristallelementen und nach dem Verfahren hergestellte Kristallelemente.

Die Kristallelemente beispielsweise für Meßwertaufnehmer werden meist unter Vermeidung des Keimlings aus dem GaPO₄- Rohkristallbarren geschnitten, geformt, geschliffen, gereinigt sowie mit Elektroden versehen und in das jeweilige Gehäuse eingebaut.

Viele Eigenschaften beispielsweise eines Meßwertaufnehmers wurden bisher fast ausschlißlich den Eigenschaften und der Bauart des Aufnehmergehäuses oder der mit der zu messenden Größe in Kontakt stehenden Membran zugeschrieben. Tatsächlich weisen jedoch Meßwertaufnehmer gleicher Bauart, ausgestattet mit den gleichen Kristallelementen, Unterschiede im Isolationsverhalten, in der Temperaturschockbelastbarkeit, der maximalen Druckbelastung und der Linearität auf, sowie kleine aber meßbare Abweichungen in wichtigen Eigenschaften wie Elastizität und piezoelektrische Empfindlichkeit.

Auch bei Resonatoren werden nachteilige Eigenschaften vor allem durch unterschiedliche Frequenzkonstanten bei gleichen Schnittwinkeln, durch unterschiedliche Temperaturkoeffizienten von Resonanzfrequenzen sowie durch irreversible Alterungsphänomene der Kristallelemente hervorgerufen.

Ein maßgebliches Qualitätskriterium für praktisch alle Anwendungen piezoelektrischer Kristallelemente ist der Spurengehalt von H₂O, wobei dieser Gehalt so niedrig wie möglich gehalten werden soll. Für Quarz und AlPO₄ sind daher Verfahren bekannt, den H₂O-Gehalt bereits von der Züchtung her zu kontrollieren. Gleiches gilt auch für die Züchtung von GaPO₄, wo z.B. mit hoher Säurekonzentration gearbeitet wird, um den H₂O-Gehalt von vornherein niedrig zu halten.

Eine weitere Möglichkeit den H₂O-Gehalt zu minimieren, bietet sich dadurch an, daß die Löslichkeit von H₂O in GaPO₄-Kristallen retrograd ist, d.h., mit steigender Temperatur sinkt. Die sich daraus ergebende Strategie der Züchtung bei hohen Temperaturen wird jedoch durch die Korrosivität der Zuchtlösung begrenzt.Bei dem aus der AT-PS 379 831 bekannten Verfahren sind bei hohen Säurekonzentrationen unter günstigen Voraussetzungen H₂O-Spurenwerte von ca. 50 ppm zu erzielen. Es ist auch hier der Einfluß der Wachstumsrate auf den H₂O-Gehalt zu berücksichtigen, sodaß bei schneller wachsenden Kristallen Wassergehalte bis zu 150 ppm gemessen werden.

Da höhere Wachstumsraten bei niedrigem Spurengehalt an H₂O anzustreben sind, müssen Methoden zur nachträglichen Reduktion des H₂O-Gehaltes angewandt werden.

Bisher sind dazu vor allen Verfahren wie Ausheizen, sowie Ausheizen im Vakuum angewandt worden, welche den Nichtgleichgewichtszustand des H₂O bei Temperaturen des Kristalls ausnützen, welche weit über seiner Züchtungstemperatur liegen. Das so erzeugte Ungleichgewicht des H₂O im Kristallgitter kann aber zu Schädigungen in der Struktur führen. Es bilden sich beispielsweise sogenannte Wasserblasen, welche die Qualitätsverbesserung durch Verminderung des H₂O-Gehaltes wieder zunichte machen.

In diesem Zusammenhang wurde auch bereits vorgeschlagen, die Kristallelemente mittels Elektrodiffusion zu behandeln. Durch den Elektrodiffusionsprozeß. d.h. anlegen hoher Spannung und dadurch induzierte Ionendiffusion, werden zwar die obengenannten Nachteile vermieden, der Prozeß ist aber ungleich aufwendiger, da die Elektrodenbereiche senkrecht zur z-Achse der Kristallelemente nach dem Diffusionsprozeß gekappt werden müssen, um die dort angereicherten Fremdionen zu entfernen.

Aufgabe der vorliegenden Erfindung ist es, ein Verfahren vorzuschlagen, mit welchem homogene GaPO₄-Kristallelemente erzielt werden, bei welchen der Spurengehalt an Wasser entscheidend vermindert werden kann. Zusätzlich sollen die Werte für alle wichtigen physikalischen Parameter, wie Elastizität und piezoelektrische Empfindlichkeit, nur geringste Streuungen aufweisen.

Diese Aufgabe wird erfindungsgemäß dadurch gelöst, daß jedes GaPO₄-Kristallelement zur Gänze aus einer einheitlichen Wachstumszone eines GaPO₄-Rohkristallbarrens geschnitten wird und frei von Zonengrenzen ist. Die Lösung der der Erfindung zugrunde liegenden Aufgabe besteht somit darin, Grenzen zwischen den einzelnen Wachstumszonen, welche eine erhöhte Versetzungsliniendichte und eine Vielzahl von Kristalldefekten aufweisen bereits beim Schneiden der GaPO₄-Kristallelemente zu vermeiden. Der an den Zonengrenzen erhöhte Wassergehalt des Rohkristallbarren kommt somit in den einzelnen zonenfrei geschnittenen Kristallelementen nicht zum Tragen. Zusätzlich sind die genannten Kristalldefekte insbesondere in Meßwertaufnehmern mit vergleichsweise hoher thermischer und mechanischer Belastung der Kristallelemente Ausgangspunkte für Bruch oder Rißbildung. Die Vermeidung von Zonengrenzen in den einzelnen Kristallelementen eines Maßelementes führt somit zu den eingangs geforderten Verbesserungen.

Da die Schwingungsgüte piezoelektrischer Elemente direkt mit dein H₂O-Spurengehalt korreliert, bringt das erfindungsgemäße Verfahren Vorteile für alle Resonatorapplikationen, aber auch für Oberflächenwellenanwendungen.

Zur Bestimmung des Wassergehaltes einer kristallinen Probe aus dem Infrarot-Spektrum genügt bei bekannter Intensität Io der Primärstrahlung und bekannter Dicke d des Kristallelementes an sich die Bestimmung der Transmission I an einer Stelle, beispielsweise bei ca. 2,9 µm (entspricht einer Wellenzahl von ca. 3.400 cm⁻¹). Für genaue Messungen kann auch zusätzlich bei einer Referenzwellenzahl gemessen werden, bei weicher nur Absorptionen des Kristallgitters wirksam sind, bzw. bei einer Wellenzahl von 3.400 cm⁻¹ eines wasserfreien Kristalls. Wasserfreie Kristalle im Sinne eines Verschwindens des Wasserpeaks bei 3.400 cm⁻¹ können relativ einfach aus deuterierten Zuchtlösungen gezüchtet werden, wobei ein Deuterierungsgrad von 99,7 % ausreicht, um den Restgehalt an Wasser unberücksichtigt zu lassen. Durch die Deuterierung wird der Schwerwasserpeak, welcher durch die O-D-Schwingungen verursacht wird, in den Bereich unter ca. 2.600 cm⁻¹ verschoben, sodaß bei 3.400 cm⁻¹ nur Absorptionen des Kristallgitters auftreten.

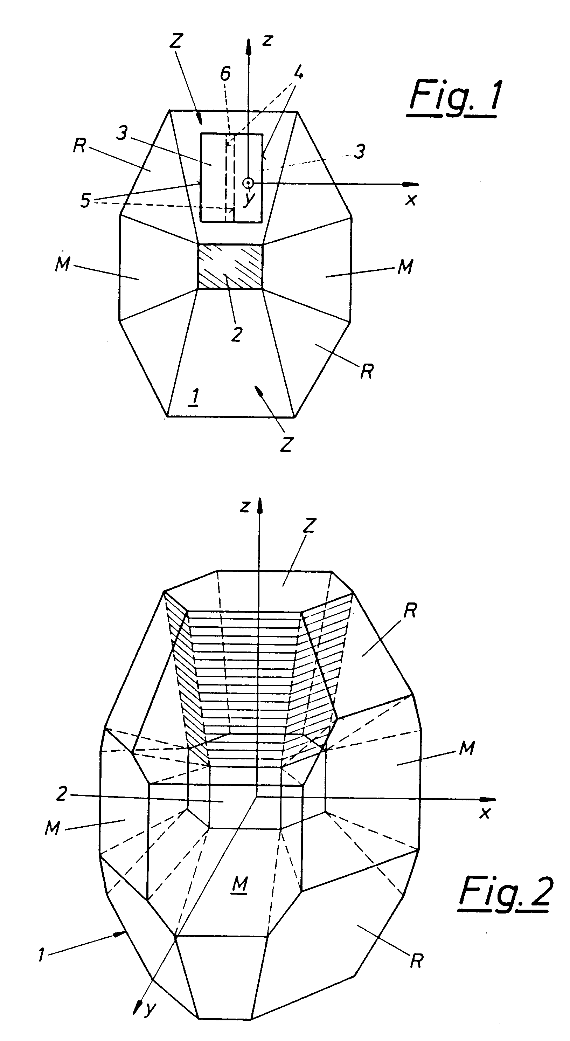

Ein erfindungsgemäßes piezoelektrisches Kristallelement mit zwei gegenüberliegenden, zur Anbringung von Elektroden vorgesehenen Seitenflächen aus einem GaPO₄-Kristall ist somit dadurch gekennzeichnet, daß jedes GaPO₄-Kristallelement zur Gänze aus einer einheitlichen Wachstumszone eines GaPO₄-Rohkristallbarrens stammt und frei von Zonengrenzen ist. Beim Wachstum von synthetischen GaPO₄-Kristallen entwickeln sich typische Wachstumszonen, welche mit M, Z und R bezeichnet werden, wie in der unten noch ausführlicher beschriebenen Fig.1 dargestellt. R-Zonen zeichnen sich dadurch aus, daß die Wachstumsfläche dieser Wachstumszonen eine Rhomboederfläche ist. Sichbar gemacht werden diese Zonen mittels Hitzebehandlung, Bestrahlung mit harter Röntgenstrahlung oder mittels Röntgentopographie.

In einer Weiterbildung der Erfindung ist vorgesehen, daß das GaPO₄-Kristallelement aus der Wachstumszone Z oder einer der einer Rhomboederfläche als Wachstumsfläche aufweisenden R-Zonen eines GaPO₄-Rohkristallbarrens stammt. Aufgrund der unterschiedlichen Wachstumsbedingungen der einzelnen Zonen sind bei GaPO₄ vor allem die R- und die Z-Zonen von Interesse, wobei letztere aufgrund ihrer größeren Wachstumsrate im allgemeinen größere Abmessungen aufweisen als die R-Zonen und bevorzugt zur Erzeugung von Kristallelementen herangezogen werden.

Im folgenden wird die vorliegende Erfindung anhand von Zeichnungen näher erläutert.Es zeigen:
- Fig. 1 und Fig. 2: die Anordnung von Wachstumszonen in einem GaPO₄-Rohkristallbarren mit einem erfindungsgemäßen GaPO₄-Kristallelement in Fig. 1,
Der in Fig. 1 schematisch dargestellte Rohkristallbarren 1 aus GaPO₄ weist im Zentrum einen Keimling 2 auf, von dessen Seitenflächen und Kanten sich mit unterschiedlicher Wachstumsgeschwindigkeit die einzelnen Wachstumszonen Z und R sowie die Mantelzonen M bilden. Der Ausdruck "Mantelzone M" ist dabei ein aus der Beschreibung von Quarzkristallen bekannter Ausdruck, welcher auch für GaPO₄-Kristalle angewandt werden kann. Mit "R-Zonen" werden Wachstumszonen bezeichnet, welche eine Rhomboederfläche als Wachstumsfläche aufweisen, wobei sich der Ausdruck Wachstumsfläche in der Kristallographie nicht auf äußere geometrische Formen, sondern auf bestimmte, durch Millerindizes charakterisierte Flächen und deren Symmetrieäquivalente bezieht. Im vorliegenden Fall der R-Zonen sind das Flächen, welche durch die Indizes {h,O,l} bzw. {O,k,l} bezeichnet werden. Die äußere geometrische Form der Begrenzungsflächen ist sowohl von der Lage der Zone als auch von der Größe des Kristalls bzw. der Wachstumszone abhängig und kann, wie in Fig. 2 dargestellt. 4-eckig oder 6-eckig sein. Aus Fig. 1 geht hervor, daß die Außenflächen der Z-Zonen senkrecht, die Außenflächen der M-Zonen parallel, sowie die Außenflächen der R-Zonen geneigt zur z-Achse stehen. Die beiden in der Wachstumszone Z dargestellten Kristallelemente 3 sind zur Gänze aus einer Zone geschnitten und somit frei von Zonengrenzen. Der strichliert eingegrenzte Bereich 6 stellt die Schnittzone zwischen den Kristallelementen 3 dar. Die kristallographischen Achsen der Kristallelemente 3 sind mit x, y und z bezeichnet. Da die Zonen mit Z-Wachstum um einiges schneller wachsen als jene mit R-Wachstum, sind die Z-Zonen leichter herstellbar und damit vorzuziehen, obwohl beispielsweise R-Zonen zur Fertigung von Meßelementen in Meßwertaufnehmern gleichermaßen geeignet sind. Mindestens zwei gegenüberliegende Seitenflächen 4,5 des Kristallelementes 3 werden vor dem Aufbringen der hier nicht dargestellten Ableitelektroden geschliffen und/oder poliert.

Fig. 2 zeigt den Rohkristallbarren in einer dreidimensionalen Darstellung mit einem prismatischen Keimling 2. Die Mantelzonen M sind im Bereich der x-y-Ebene engordnet, die R-Zonen zwischen den Z-Zonen und den Mantelzonen M.

## Patentansprüche

1. Verfahren zur Verringerung des Wassergehaltes in piezoelektrischen GaPO₄-Kristallelementen, **dadurch gekennzeichnet**, daß jedes GaPO₄-Kristallelement zur Gänze aus einer einheitlichen Wachstumszone eines GaPO₄-Rohkristallbarrens geschnitten wird und frei von Zonengrenzen ist.

2. Piezoelektrisches Kristallelement mit zwei gegenüberliegenden, zur Anbringung von Elektroden vorgesehenen Seitenflächen aus einem GaPO₄-Kristall, **dadurch gekennzeichnet**, daß jedes GaPO₄-Kristallelement (3) zur Gänze aus einer einheitlichen Wachstumszone eines GaPO₄-Rohkristallbarrens (1) stammt und frei von Zonengrenzen ist.

3. Piezoelektrisches Kristallelement nach Anspruch 2, dadurch gekennzeichnet, daß das GaPO₄-Kristallelement (3) aus der Wachstumszone Z oder einer der eine Rhomboederfläche als Wachstumsfläche aufweisenden R-Zonen eines GaPO₄-Rohkristallbarrens (1) stammt.

## Claims

1. A method of reducing the water content in piezoelectric GaPO₄ crystal elements, wherein each of said piezoelectric GaPO₄ crystal elements is cut entirely from one uniform growth zone of a GaPO₄ raw crystal bar, and is free of any zone boundaries.

2. A piezoelectric crystal element with two opposite faces for the application of electrodes, which is made from a GaPO₄ crystal, wherein each of said GaPO₄ crystal elements (3) comes entirely from one uniform growth zone of a GaPO₄ crystal bar (1) and contains no zone boundaries.

3. A piezoelectric crystal element according to claim 2, wherein said GaPO₄ crystal element (3) is chosen from the growth zone Z or one of the R zones having rhombohedral growth faces of said GaPO₄ raw crystal bar (1).

## Revendications

1. Procédé de réduction de la teneur en eau dans des éléments de cristal GaPO₄ piézoélectriques, caractérisé en ce que chaque élément de cristal GaPO₄ est découpé dans sa totalité d'une zone de croissance uniforme d'une barre ou bloc de cristal brut GaPO₄ et est dépourvu de limites de zones.

2. Elément de cristal piézoélectrique avec deux faces latérales opposées prévues pour appliquer des électrodes, provenant d'un cristal GaPO₄, caractérisé en ce que chaque élément de cristal GaPO₄ (3) provient en totalité d'une zone de croissance uniforme d'une barre ou bloc de cristal brut GaPO₄ (1) et est dépourvu de limites de zones.

3. Elément de cristal piézoélectrique selon la revendication 2, caractérisé en ce que l'élément de cristal GaPOₐ (3) provient de la zone de croissance Z ou d'une des zones R d'une barre ou bloc de cristal brut GaPO₄ (1) comportant une face de rhomboèdre comme face de croissance.
